(19) Europäisches Patentamt

European Patent Office

Office européen des brevets

(11) **EP 1 703 329 A1**

(12) **EUROPEAN PATENT APPLICATION**

(43) Date of publication:
**20.09.2006 Bulletin 2006/38**

(51) Int Cl.:
***G03F 7/20*** (2006.01)

(21) Application number: **06111260.3**

(22) Date of filing: **16.03.2006**

| | |
|---|---|
| (84) Designated Contracting States:<br>**AT BE BG CH CY CZ DE DK EE ES FI FR GB GR HU IE IS IT LI LT LU LV MC NL PL PT RO SE SI SK TR**<br>Designated Extension States:<br>**AL BA HR MK YU**<br><br>(30) Priority: **18.03.2005 JP 2005080588**<br><br>(71) Applicant: **CANON KABUSHIKI KAISHA**<br>**Ohta-ku, Tokyo (JP)** | (72) Inventors:<br>• **Makita, Yoshinori**<br>**Tokyo**<br>**Tokyo 146-8501 (JP)**<br>• **Ogino, Kaoru**<br>**Tokyo**<br>**Tokyo 146-8501 (JP)**<br><br>(74) Representative: **TBK-Patent**<br>**Bavariaring 4-6**<br>**80336 München (DE)** |

(54) **Immersion exposure apparatus, immersion exposure method, and device manufacturing method**

(57)     An immersion exposure apparatus projects and transfers a pattern onto a photosensitive substrate through a projection optical system with a liquid (42) being supplied to the immersion space between the projection optical system and the photosensitive substrate. The immersion exposure apparatus includes a temperature detector (34) which detects the temperature of the liquid in the immersion space, and a controller (28) which controls, on the basis of an output from the temperature detector, the position and/or tilt of a movable unit (52) that influences the imaging performance of the pattern to be projected onto the photosensitive substrate.

FIG. 1

EP 1 703 329 A1

**Description**

FIELD OF THE INVENTION

The present invention relates to an immersion exposure technique of exposing a photosensitive substrate with a liquid being supplied between a projection optical system and the photosensitive substrate.

BACKGROUND OF THE INVENTION

As micropatterning of semiconductor devices advances, a shift to an exposure light source which generates light having a shorter wavelength, i.e., a shift from a high-pressure mercury-vapor lamp (a g-line or i-line) to a KrF excimer laser or ArF excimer laser is in progress. In order to attain a higher resolving power, the NA (numerical aperture) of a projection optical system needs to be increased. This decreases the depth of focus. The relationship between these factors can be generally expressed by:

$$(\text{resolving power}) = k_1 \cdot (\lambda/NA)$$

$$(\text{depth of focus}) = \pm k_2 \cdot (\lambda/NA^2)$$

where $\lambda$ is the wavelength of exposure light, NA is the numerical aperture of a projection lens, and $k_1$ and $k_2$ are coefficients which depend on the process involved.

As a means for increasing the resolving power and depth of focus, it has been proposed and even practiced to use phase shift masks or modified illuminations. As another means for increasing the resolving power and depth, there is known an immersion exposure technique. This immersion exposure technique executes exposure by supplying a liquid having a high refractive index between the wafer surface (image plane) and the lowermost surface of a projection optical system.

The space between the image plane and the lowermost surface of the projection optical system is called a working distance. In a conventional exposure apparatus, the working distance is filled with air. The working distance is normally set to 10 mm or more so as to accommodate an auto-focus system in this space. On the other hand, the pattern to be transferred onto a wafer is increasingly micronized. To cope with this trend, the exposure wavelength must be shortened or the numerical aperture must be increased. However, the kinds of glass materials that can transmit light having a short wavelength therethrough are limited. Hence, the immersion technique of filling the working distance with a liquid is useful for increasing the numerical aperture.

In an immersion exposure apparatus, the refractive index of a liquid supplied to the working distance may vary due to a temperature variation of the liquid. As a countermeasure against deterioration in imaging performance due to a temperature variation of a liquid, the following technique has been proposed. U.S. Patent No. 4,346,164 discloses a technique of stabilizing the liquid temperature by a temperature stabilization mechanism. Japanese Patent Laid-Open No. 6-124873 discloses a technique of making the liquid temperature uniform. Japanese Patent Laid-Open No. 10-340846 discloses a technique of changing the liquid concentration in real time to adjust the refractive index of the liquid.

Unfortunately, the techniques described in U.S. Patent No. 4,346,164 and Japanese Patent Laid-Open No. 6-124873 require temperature control with an accuracy that is practically impossible. The technique described in Japanese Patent Laid-Open No. 10-340846 requires control of the liquid concentration in real time again with an accuracy practically impossible in view of liquid temperature nonuniformity which has a largest influence on the imaging performance. For these reasons, all the prior art techniques suffer a large number of problems to be solved for practical applications.

SUMMARY OF THE INVENTION

The present invention has been made in consideration of the above situation, and has as its exemplary object to suppress degradation in imaging performance due to a temperature variation of a liquid with high accuracy by controlling a readily controllable object.

According to the first aspect of the present invention, there is provided an immersion exposure apparatus which projects and transfers a pattern onto a photosensitive substrate through a projection optical system with a liquid being supplied to an immersion space between the projection optical system and the photosensitive substrate, comprising a temperature detector which detects a temperature of the liquid in the immersion space, and a controller which controls, on the basis of an output from the temperature detector, a position and/or tilt of a movable unit that influences imaging performance of the pattern to be projected onto the photosensitive substrate.

According to a preferred embodiment of the present invention, the movable unit can include a stage which supports the photosensitive substrate. Alternatively, the movable unit can include an optical element which forms the projection optical system. Alternatively, the movable unit can include a stage which supports an original having the pattern to be projected onto the photosensitive substrate.

According to the preferred embodiment of the present invention, the controller can control the position and/or tilt of the movable unit to correct at least one of a shift in focus position, shift in projection magnification, and aberration of the pattern to be projected onto the photosensitive substrate.

According to the preferred embodiment of the present invention, the temperature detector can detect a temperature distribution of the liquid in the immersion space. Alternatively, the temperature detector can detect the temperature of the liquid in the immersion space on the basis of an output from a temperature sensor arranged outside the immersion space. The temperature detector can include a temperature sensor which detects a temperature of a liquid supplied to the immersion space, and a temperature sensor which detects a temperature of a liquid recovered from the immersion space.

According to the second aspect of the present invention, there is provided an immersion exposure method of projecting and transferring a pattern onto a photosensitive substrate through a projection optical system with a liquid being supplied to an immersion space between the projection optical system and the photosensitive substrate, comprising a temperature detection step of detecting a temperature of the liquid in the immersion space, and a control step of controlling, on the basis of information obtained in the temperature detection step, a position and/or tilt of a movable unit that influences imaging performance of the pattern to be projected onto the photosensitive substrate.

The present invention can, for example, suppress degradation in imaging performance due to a temperature variation of a liquid with high accuracy by controlling a readily controllable object.

Other features and advantages of the present invention will be apparent from the following description taken in conjunction with the accompanying drawings, in which like reference characters designate the same or similar parts throughout the figures thereof.

BRIEF DESCRIPTION OF THE DRAWINGS

The accompanying drawings, which are incorporated in and constitute a part of the specification, illustrate embodiments of the invention and, together with the description, serve to explain the principles of the invention.

Fig. 1 is a view schematically showing the arrangement of a projection exposure apparatus according to a preferred embodiment of the present invention;
Fig. 2 is a flowchart showing the flow of the overall semiconductor device manufacturing process; and
Fig. 3 is a flowchart showing the detailed flow of the wafer process.

DETAILED DESCRIPTION OF THE PREFERRED EMBODIMENT

The principle of the present invention will be described first.

Letting L be the distance from the end face (lowermost surface) of a projection optical system to the imaging surface'(substrate surface), i.e., the working distance, $\Delta T$ be the width of a temperature variation of a medium which fills the working distance L, $\Delta F$ be the wave aberration of the imaging surface due to the temperature distribution $\Delta T$, and N be the temperature coefficient of the refractive index of the medium,

$$\Delta F = L \times |N| \times \Delta T \qquad \ldots (1)$$

approximately holds.

The medium is assumed to have a temperature distribution width (temperature variation width) $\Delta T$ of about 0.01°C even if the temperature is controlled to be uniform as much as possible. Hence, the wave aberration $\Delta F$ of the imaging surface takes at least a value expressed by:

$$\Delta F = L \times |N| \times 0.01 \qquad \ldots (2)$$

where N is the value of the temperature coefficient of the refractive index (unit: 1/°C).

A liquid and gas have largely different temperature coefficients N of the refractive index. For example, air has a value of N = -9 x $10^{-7}$/°C, and water has a value of N = -8 $\times$ $10^{-5}$/°C. The value of water is almost 100 times that of air. On the other hand, the working distance L of a projection optical system in a reduction projection exposure apparatus is normally larger than 10 mm. Hence, even if the distance L is estimated to be as small as, i.e., L = 10 mm, the wave aberration ΔF of the imaging surface is expressed by:

$$\Delta F = 10 \text{ mm} \times |-9 \times 10^{-7}/°C| \times 0.01°C = 0.09 \text{ nm}$$

$$\text{if the medium is air, and}$$

$$\Delta F = 10 \text{ mm} \times |-8 \times 10^{-5}/°C| \times 0.01°C = 8.0 \text{ nm}$$

$$\text{if the medium is water.} \qquad \ldots (3)$$

When an ArF excimer laser beam having a wavelength of λ = 193 nm is used as exposure light, the wave aberration ΔF of the imaging surface is generally desired to satisfy a condition:

$$\Delta F < \lambda/25 \qquad \ldots (4)$$

Also, when a KrF excimer laser beam having a wavelength of λ = 248 nm is used as exposure light, the wave aberration ΔF of the imaging surface is desired to satisfy a condition:

$$\Delta F < \lambda/30 \qquad \ldots (5)$$

Assume that the medium which fills the working distance is water, and the working distance L exceeds 10 mm. In this case, the wave aberration of the imaging surface due to a temperature variation of the medium is too large for practical applications.

From equations (2) and (4), we have

$$L < \lambda/(0.25 \times |N|) \qquad \ldots (6)$$

From equations (2) and (5), we have

$$L < \lambda/(0.30 \times |N|) \qquad \ldots (7)$$

When equation (6) or (7) is satisfied, an immersion exposure apparatus that has a projection optical system which suppresses a wave aberration generated by a temperature variation of the immersion liquid to be smaller than 1/25 or 1/30 the exposure wavelength under a practically attainable temperature stability (temperature distribution) can be obtained.

As described above, a wave aberration ΔF generated when exposure light is transmitted through a medium having a temperature distribution width (temperature variation width) ΔT depends on the product of the temperature distribution width ΔT and an optical path length L in the medium. Therefore, the optical path length L can be corrected by measuring the temperature distribution width. This makes it possible to provide an immersion exposure apparatus which suppresses the wave aberration to an allowable level even in liquid temperature control with a practically attainable accuracy.

A preferred embodiment of the present invention will be described below.

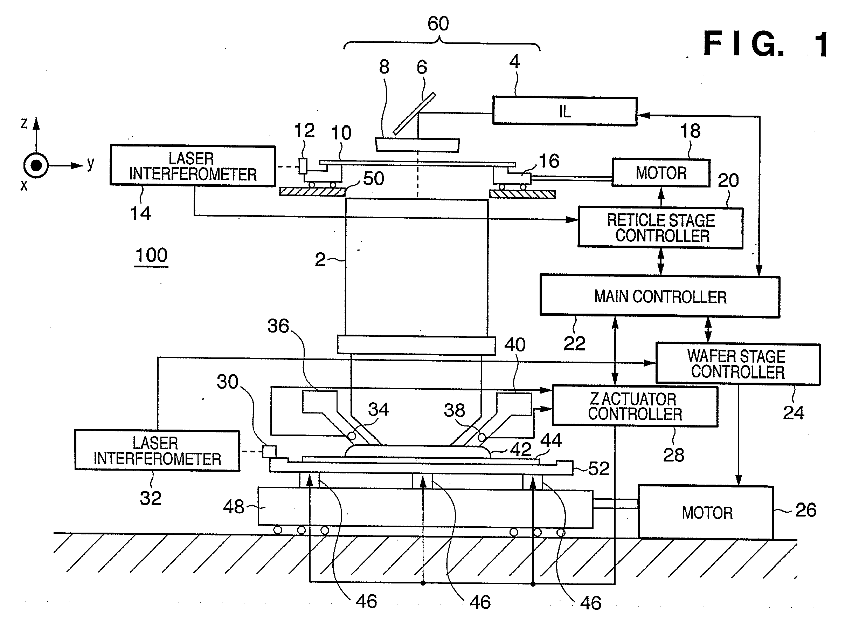

Fig. 1 is a view schematically showing the arrangement of a projection exposure apparatus according to the preferred embodiment of the present invention. In this case, a lens scan projection exposure apparatus to which the present invention is applied will be exemplified. However, the present invention can be applied to a full-plate transfer projection exposure apparatus.

In the projection exposure apparatus according to the preferred embodiment of the present invention, a circuit pattern formed on a reticle (original) 10 is projected, through a reduction projection optical system 2, onto a wafer (photosensitive substrate) 44 coated with a photosensitive agent, thereby forming a latent image pattern on the photosensitive agent. The reduction projection optical system 2 has a circular imaging field formed in a telecentric system on the object side, and a circular image field formed in the telecentric system on the image side. The reticle 10 and wafer 44 are driven by scanning with respect to the reduction projection optical system 2.

An illumination system 60 includes an ArF excimer laser light source (not shown), a beam expander (not shown), an optical integrator 4 such as a fly-eye lens, a collimator lens system 8, a reticle blind (an illumination field stop arranged in the optical integrator 4; not shown), and a relay optical system (arranged in the optical integrator 4 and not shown). The ArF excimer laser light source emits pulse light having a wavelength of 193 nm. The beam expander shapes the section of the pulse light emitted from the light source into a predetermined shape. The optical integrator 4 receives the shaped pulse light to form a secondary source image (one set of a plurality of light sources). The collimator lens system 8 condenses pulse light from the secondary source image to form pulse illumination light having a uniform illuminance distribution. The reticle blind shapes the pulse illumination light into a rectangular having a long side in a direction perpendicular to the scanning direction in scanning exposure. The relay optical system images a rectangular aperture of the reticle blind on the reticle 10 in cooperation with a mirror 6 and the collimator lens system 8.

Reticle stages 16 hold the reticle 10 by the vacuum chucking force. The reticle stage 16 is movable in one axial direction by a long stroke at a predetermined speed during scanning exposure. The reticle stages 16 are driven by scanning on cylindrical structures 50 of the exposure apparatus main body in the y direction (the one horizontal direction).

A laser interferometer 14 continuously measures the coordinate position of the reticle stage 16 in the x-y plane and its slight rotational shift. The laser interferometer 14 emits a laser beam toward a mirror (plane mirror or corner mirror) 12 attached to part of the reticle stage 16. The laser interferometer 14 receives a laser beam reflected by the mirror. A reticle stage controller 20 controls a motor (e.g., a linear motor) 18 to drive the reticle stage 16 on the basis of a coordinate position in the x-y plane measured by the laser interferometer 14. With this operation, scanning'movement of the reticle stage 16 is controlled.

When part of the circuit pattern region of the reticle 10 is illuminated with shaped pulse light, an imaging light beam which emerges from the circuit pattern of the illuminated portion is projected, through the reduction projection optical system (e.g., a 1/4 reduction projection optical system) 2, onto a photosensitive agent (photoresist) applied to the wafer 44, thereby imaging the circuit pattern. The optical axis of the reduction projection optical system 2 is positioned to coincide with that of the illumination system 60.

The reduction projection optical system 2 has a plurality of lens elements (optical elements). These lens elements can be made of two kinds of materials, e.g., quartz and fluorite each having a high transmittance for ultraviolet rays having a wavelength of 193 nm. Fluorite is mainly used to form a lens element with positive power. Air in a lens barrel to which the lens elements of the reduction projection optical system 2 are fixed is replaced with nitrogen gas. This prevents oxygen from absorbing pulse illumination light having a wavelength of 193 nm. Air in the optical path from the interior of the light source 4 to the collimator lens system 8 is also replaced with nitrogen gas. In the other embodiments, the reduction projection optical system may include a mirror.

The wafer 44 is held by a wafer holder (chuck; not shown) on a Z-tilt stage 52. The wafer holder vacuum-chucks the reverse surface of the wafer 44. The Z-tilt stage 52 can be translated in the z direction along with the optical axis of the reduction projection optical system 2. Also, the Z-tilt stage 52 is movable in a direction perpendicular to the optical axis during its tilt movement with respect to the x-y plane. The Z-tilt stage 52 is attached to an X-Y stage 48 by inserting a plurality of (e.g., three) Z actuators 46. The X-Y stage 48 is'movable two-dimensionally, i.e., in the x and y directions. The Z actuator 46 can be formed by combining, e.g., a piezoelectric element, a voice coil motor or DC motor, and a lift/cam mechanism.

When all the Z actuators 46 drive the Z-tilt stage 52 in the z direction by the same amount, the Z-tilt stage 52 is translated in the z direction (i.e., the focusing direction) while being parallel to the X-Y stage 48. If each Z actuator 46 drives the Z-tilt stage 52 in the z direction by a different amount, the tilt amount and tilt direction of the Z-tilt stage 52 are adjusted.

The X-Y stage 48 is two-dimensionally driven by a plurality of driving motors. The driving motors can include a DC motor to rotate a feed screw, and/or a linear motor to generate the driving force in a noncontact state. A wafer stage controller 24 controls the driving motors. The wafer stage controller 24 is notified of a coordinate position measured by a laser interferometer 32 so as to measure a change in position of the reflection surface of a mirror 30 in the x and y directions.

An immersion exposure apparatus 100 executes exposure by filling the optical path between the wafer 44 and the end face of the projection optical system 2 with a liquid 42.

A liquid supply unit 36 supplies the liquid 42 to the immersion space between the wafer 44 and the end face of the reduction projection optical system 2. A liquid recovery unit 40 recovers the liquid 42 from the immersion space.

One or a plurality of supply-side temperature sensors 34 are arranged in, e.g., the liquid supply unit 36 as the side which supplies a liquid to the immersion space. One or a plurality of recovery-side temperature sensors 38 are arranged in, e.g., the liquid recovery unit 40 as the side which recovers the liquid from the immersion space. An arithmetic unit can be arranged inside or outside a Z actuator controller 28 so as to measure, on the basis of outputs from the temperature sensors 34 and 38, the temperature or a temperature variation of the liquid 42 in the immersion space to several, i.e., three to four decimal places below the decimal point (unit: °C).

Assume that the liquid is pure water. In this case, on the basis of the temperature or a temperature variation of the liquid 42 in the immersion space, the Z actuator controller 28 calculates the variation amount of the refractive index of the liquid by the above equation ($N = -8 \times 10^{-5}/°C$). For example, when an ArF excimer laser beam ($\lambda = 193$ nm) is used as exposure light, the wave aberration $\Delta F$ of the imaging surface should be smaller than 7.7 nm ($\lambda/25$), as expressed by equation (4). To achieve this, on the basis of the temperature and the variation amount of the refractive index of the liquid 42, the Z actuator controller 28 calculates a working distance L which satisfies $\Delta F < 7.7$ nm in accordance with equation (1). The Z actuator controller 28 then controls driving of the Z actuators 46 so as to set the working distance L to a calculated value. Hence, a good imaging performance can be obtained.

That is, in this embodiment, the temperature or a temperature variation of a liquid in an immersion space is detected (detection includes estimation by an arithmetic process or the like). On the basis of the resultant temperature or temperature variation, the working distance L is so adjusted as to correct a wave aberration $\Delta F$ generated by a variation in refractive index of the liquid. Moreover, if the temperature of the liquid 42 in the immersion space is nonuniform in the x-y plane (typically, if a temperature gradient is detected), the plurality of Z actuators 46 may be driven to eliminate the nonuniformity of a wave aberration due to the temperature nonuniformity, thus controlling the position and/or tilt of the Z-tilt stage. Note that a temperature gradient in the direction in which the liquid 42 flows can be detected on the basis of outputs from the supply-side temperature sensor 34 and recovery-side temperature sensor 38. The other temperature nonuniformities can be detected by increasing the number of temperature sensors, or using a temperature sensor capable of measuring the temperature of each one- or two-dimensional position.

In this case, as temperature sensors exemplified using the temperature sensors 34 and 38, a noncontact sensor such as a thermistor or platinum temperature sensor, or a noncontact sensor such as a thermography device is preferable. The noncontact temperature sensors such as the thermistor or platinum temperature sensor can be conveniently positioned on the side which supplies a liquid to the immersion space (e.g., liquid supply unit 36), and positioned on the side which recovers the liquid from the immersion space (e.g., liquid recovery unit 40). The noncontact temperature sensors such as the thermography device can be conveniently positioned on the side surface of the immersion space and the reduction projection optical system 2 to detect the temperature distribution (typically, the temperature gradient).

Although the above-mentioned immersion exposure apparatus 100 adopts a local fill method, the present invention can also be applied to other immersion methods.

Also, the above-mentioned immersion exposure apparatus 100 drives a wafer to correct a wave aberration (variation in focus position) generated by a variation in refractive index due to a temperature variation of a liquid in an immersion space. Alternatively, optical elements which form the reduction projection optical system 2 can be driven in the z direction and/or tilt direction to move and/or tilt the image plane, thereby correcting the wave aberration. Moreover, a variation in refractive index of the liquid in the immersion space varies the focus position, and additionally generates various aberrations such as distortion and a variation in projection magnification of the projection optical system 2. These aberrations can also be corrected by driving, in the z direction and/or tilt direction, the reticle stages 16 and the optical elements which form the projection optical system 2. That is, the present invention can be employed to correct, on the basis of the temperature of the liquid in the immersion space, at least one of a shift in focus position, shift in projection magnification, and aberration by driving a movable unit such as the Z-tilt stage 52, the reticle stages 16, or the optical elements in the reduction projection optical system 2.

As described above, according to this embodiment, the image plane of the projection optical system 2 is matched with the wafer surface so as to correct a wave aberration generated by a variation in refractive index due to a temperature variation of a liquid in an immersion space. This makes it possible to perform focus correction in real time.

Moreover, the imaging performance of a pattern to be projected onto a photosensitive substrate (e.g., at least one of a shift in focus position, shift in projection magnification, and aberration of the pattern to be transferred onto a photosensitive substrate) will be degraded by a variation in refractive index due to a temperature variation of a liquid in an immersion space. According to this embodiment, such degradation can be suppressed by driving, in the z direction and/or tilt direction, at least one of a stage which supports a substrate, optical elements which form a projection optical system, and a stage which supports an original.

A semiconductor manufacturing process which exemplifies a device manufacturing process using the above-mentioned immersion exposure apparatus will be described next.

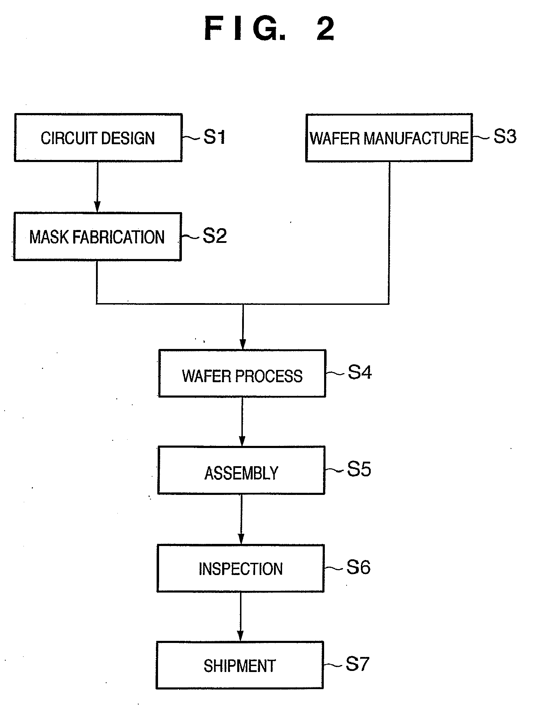

Fig. 2 is a flowchart showing the flow of the overall semiconductor device manufacturing process. In step 1 (circuit design), a semiconductor device circuit is designed. In step 2 (mask fabrication), a mask is fabricated on the basis of the designed circuit pattern. In step 3 (wafer manufacture), a wafer is manufactured using a material such as silicon. In step 4 (wafer process) called a pre-process, an actual circuit is formed on the wafer by lithography using the mask and wafer. In step 5 (assembly) called a post-process, a semiconductor chip is formed by using the wafer manufactured in step 4. This step includes an assembly step (dicing and bonding) and packaging step (chip encapsulation). In step 6 (inspection), the semiconductor device manufactured in step 5 undergoes inspections such as an operation confirmation test and durability test. After these steps, the semiconductor device is completed and shipped in step 7.

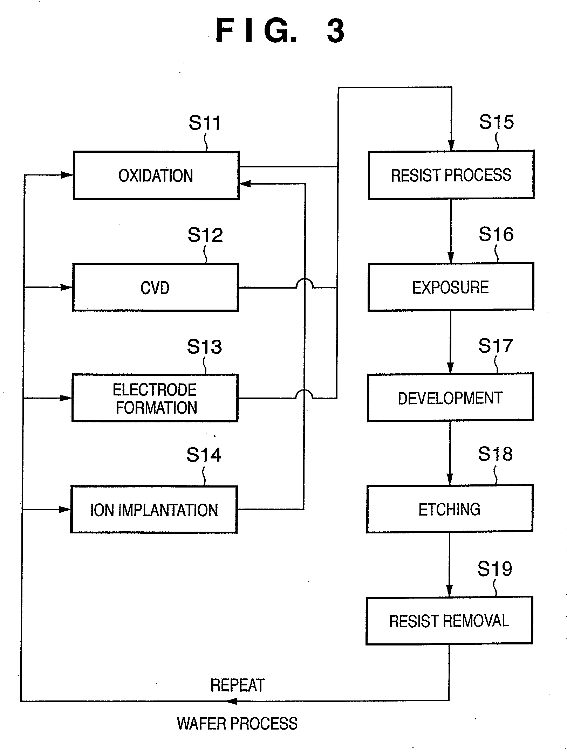

Fig. 3 shows the detailed flow of the wafer process. In step 11 (oxidation), the wafer surface is oxidized. In step 12 (CVD), an insulating film is formed on the wafer surface. In step 13 (electrode formation), an electrode is formed on the wafer by vapor deposition. In step 14 (ion implantation), ions are implanted in the wafer. In step 15 (resist process), a photosensitive agent is applied to the wafer. In step 16 (exposure), the above-mentioned exposure apparatus transfers a circuit pattern onto the wafer coated with the photosensitive agent to form a latent image pattern. In step 17 (development), the latent image pattern formed on the wafer coated with the photosensitive agent is developed. In step 18 (etching), etching is performed using, as a mask, a pattern formed by development. In step 19 (resist removal), any unnecessary resist remaining after etching is removed. These steps are repeated to form multiple circuit patterns on the wafer.

As many apparently widely different embodiments of the present invention can be made without departing from the spirit and scope thereof, it is to be understood that the invention is not limited to the specific embodiments thereof except as defined in the claims.

An immersion exposure apparatus projects and transfers a pattern onto a photosensitive substrate through a projection optical system with a liquid being supplied to the immersion space between the projection optical system and the photosensitive substrate. The immersion exposure apparatus includes a temperature detector which detects the temperature of the liquid in the immersion space, and a controller which controls, on the basis of an output from the temperature detector, the position and/or tilt of a movable unit that influences the imaging performance of the pattern to be projected onto the photosensitive substrate.

**Claims**

1.  An immersion exposure apparatus which projects and transfers a pattern onto a photosensitive substrate through a projection optical system with a liquid being supplied to an immersion space between the projection optical system and the photosensitive substrate, comprising
    a temperature detector which detects a temperature of the liquid in the immersion space, and
    a controller which controls, on the basis of an output from said temperature detector, a position and/or tilt of a movable unit that influences imaging performance of the pattern to be projected onto the photosensitive substrate.

2.  The apparatus according to claim 1, wherein the movable unit includes a stage which supports the photosensitive substrate.

3.  The apparatus according to claim 1, wherein the movable unit includes an optical element which forms the projection optical system.

4.  The apparatus according to claim 1, wherein the movable unit includes a stage which supports an original having the pattern to be projected onto the photosensitive substrate.

5.  The apparatus according to claim 1, wherein said controller controls the position and/or tilt of the movable unit to correct at least one of a shift in focus position, shift in projection magnification, and aberration of the pattern to be projected onto the photosensitive substrate.

6.  The apparatus according to claim 1, wherein said temperature detector detects a temperature distribution of the liquid in the immersion space.

7.  The apparatus according to claim 1, wherein said temperature detector detects the temperature of the liquid in the immersion space on the basis of an output from a temperature sensor arranged outside the immersion space.

8.  The apparatus according to claim 1, wherein said temperature detector includes a temperature sensor which detects a temperature of a liquid supplied to the immersion space, and a temperature sensor which detects a temperature of a liquid recovered from the immersion space.

**9.** An immersion exposure method of projecting and transferring a pattern onto a photosensitive substrate through a projection optical system with a liquid being supplied to an immersion space between the projection optical system and the photosensitive substrate, the method comprising
a temperature detection step of detecting a temperature of the liquid in the immersion space, and
a control step of controlling, on the basis of information obtained in the temperature detection step, a position and/or tilt of a movable unit that influences imaging performance of the pattern to be projected onto the photosensitive substrate.

**10.** A device manufacturing method comprising steps of
forming a latent image pattern on a photosensitive substrate by using an immersion exposure apparatus defined in claim 1, and
developing the latent image pattern.

**FIG. 1**

EP 1 703 329 A1

# F I G. 2

CIRCUIT DESIGN — S1

WAFER MANUFACTURE — S3

MASK FABRICATION — S2

WAFER PROCESS — S4

ASSEMBLY — S5

INSPECTION — S6

SHIPMENT — S7

# F I G.  3

```
         S11                           S15
   ┌──────────────┐              ┌──────────────────┐
   │  OXIDATION   │              │  RESIST PROCESS  │
   └──────────────┘              └──────────────────┘

         S12                           S16
   ┌──────────────┐              ┌──────────────────┐
   │     CVD      │              │    EXPOSURE      │
   └──────────────┘              └──────────────────┘

         S13                           S17
   ┌──────────────┐              ┌──────────────────┐
   │  ELECTRODE   │              │   DEVELOPMENT    │
   │  FORMATION   │              └──────────────────┘
   └──────────────┘

         S14                           S18
   ┌──────────────┐              ┌──────────────────┐
   │ION IMPLANTATION│            │     ETCHING      │
   └──────────────┘              └──────────────────┘

                                       S19
                                 ┌──────────────────┐
                                 │  RESIST REMOVAL  │
                                 └──────────────────┘
```

REPEAT

WAFER PROCESS

**European Patent Office**

**EUROPEAN SEARCH REPORT**

Application Number

EP 06 11 1260

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2004/053955 A (NIKON CORPORATION; HIRUKAWA, SHIGERU; MAGOME, NOBUTAKA; TANAKA, ISSEY) 24 June 2004 (2004-06-24) * abstract * | 1-6,9,10 | INV. G03F7/20 |
| P,X | -& EP 1 571 697 A (NIKON CORPORATION) 7 September 2005 (2005-09-07) * paragraph [0191]; figure 10a * * paragraph [0233] - paragraph [0234]; figure 6 * ----- | 1-6,9,10 | |
| X | WO 2004/107417 A (NIKON CORPORATION; HIRUKAWA, SHIGERU) 9 December 2004 (2004-12-09) * abstract * | 1,2,5-10 | |
| P,X | -& EP 1 628 330 A (NIKON CORPORATION) 22 February 2006 (2006-02-22) * paragraph [0063] * * paragraph [0115] - paragraph [0123]; figures 14,15 * ----- | 1,2,5,6, 8-10 | |
| | | | TECHNICAL FIELDS SEARCHED (IPC) |
| | | | G03F |

The present search report has been drawn up for all claims

| Place of search | Date of completion of the search | Examiner |
|---|---|---|
| Munich | 3 July 2006 | van Toledo, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 11 1260

This annex lists the patent family members relating to the patent documents cited in the above-mentioned European search report.
The members are as contained in the European Patent Office EDP file on
The European Patent Office is in no way liable for these particulars which are merely given for the purpose of information.

03-07-2006

| Patent document cited in search report | | Publication date | Patent family member(s) | | Publication date |
|---|---|---|---|---|---|
| WO 2004053955 | A | 24-06-2004 | AU | 2003289239 A1 | 30-06-2004 |
| | | | CN | 1723542 A | 18-01-2006 |
| | | | EP | 1571697 A1 | 07-09-2005 |
| | | | US | 2005259234 A1 | 24-11-2005 |
| | | | US | 2006119820 A1 | 08-06-2006 |
| EP 1571697 | A | 07-09-2005 | AU | 2003289239 A1 | 30-06-2004 |
| | | | CN | 1723542 A | 18-01-2006 |
| | | | WO | 2004053955 A1 | 24-06-2004 |
| | | | US | 2005259234 A1 | 24-11-2005 |
| | | | US | 2006119820 A1 | 08-06-2006 |
| WO 2004107417 | A | 09-12-2004 | EP | 1628330 A1 | 22-02-2006 |
| | | | US | 2006082744 A1 | 20-04-2006 |
| | | | US | 2006098179 A1 | 11-05-2006 |
| EP 1628330 | A | 22-02-2006 | WO | 2004107417 A1 | 09-12-2004 |
| | | | US | 2006082744 A1 | 20-04-2006 |
| | | | US | 2006098179 A1 | 11-05-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4346164 A
- JP 6124873 A
- JP 10340846 A